(19)

Europäisches
Patentamt
European
Patent Office
Office européen
des brevets

(11) **EP 4 672 340 A1**

(12) **EUROPEAN PATENT APPLICATION**

(43) Date of publication:
**31.12.2025 Bulletin 2026/01**

(21) Application number: **24184707.8**

(22) Date of filing: **26.06.2024**

(51) International Patent Classification (IPC):
*H01L 29/32* (2006.01)    *H01L 29/739* (2006.01)

(52) Cooperative Patent Classification (CPC):
**H10D 62/53; H10D 12/038; H10D 12/481**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Nexperia B.V.
6534 AB Nijmegen (NL)**

(72) Inventor: **Saito, Katsuaki
Tokyo (JP)**

(74) Representative: **Pjanovic, Ilija
Nexperia B.V.
Legal & IP
Jonkerbosplein 52
6534 AB Nijmegen (NL)**

(54) **SEMICONDUCTOR DEVICE AND METHOD OF ION IMPLEMENTATION IN A SEMICONDUCTOR DEVICE**

(57)    The present disclosure relates to a semiconductor device, such as a Reverse Conducting Insulated Gate Bipolar Transistor, RC-IGBT, and method of ion implementation in a semiconductor device, especially implementation of light ion particles.

A semiconductor device is proposed, comprising a semiconductor structure layer and a metal electrode (21) on at least one surface of the semiconductor layer, wherein the metal electrode (21) comprise at least one thin metal electrode section (21a) and at least one thick metal electrode section (21b). Preferably the at least one thin metal electrode section (21a) has a thickness of 4-7 $\mu$m and the at least one thick metal electrode section (21b) has a thickness of 9-14 $\mu$m.

Fig. 13

**EP 4 672 340 A1**

**Description**

TECHNICAL FIELD

The present disclosure relates to a semiconductor device, such as a Reverse Conducting Insulated Gate Bipolar Transistor, RC-IGBT, and a method of ion implementation in a semiconductor device, especially implementation of light ion particles.

BACKGROUND OF THE DISCLOSURE

Accordingly, it is a goal of the present disclosure to provide an improved RC-IGBT, and method of ion implementation in a semiconductor device, especially implementation of light ion particles
Japanese Patent Application JP2022167435A, relates to the area-limited implantation of light particles utilizing a metal mask. Notably, the application does not address enhancements in alignment precision. Furthermore, the disclosed device is not a Reverse Conducting Insulated Gate Bipolar Transistor (RC-IGBT). Instead, it integrates Insulated Gate Bipolar Transistors (IGBTs) with varying switching speeds into a singular chip. Additionally, the thickness of the metal electrode remains consistent for both the high-speed and low-speed IGBTs.
Japanese Patent Application JP2021190496A discloses a method for area-limited implantation of light particles. Two methods are presented: one employing a metal mask, similar to the technique described in JP2022167435A, and the other utilizing a thick resist. The thickness of the resist is not specified. Additionally, the thickness of the metal electrode is uniform for both the IGBT and the diode sections.
In solutions known from prior art, the metal electrode is not used as a mask for light ion implantation. Instead, a separate metal mask is employed, which presents challenges in achieving high-accuracy alignment between the metal mask and the wafer. Although resist masks are mentioned, the resist, being composed of organic material, needs to be extremely thick.

SUMMARY OF THE DISCLOSURE

According to a first example of the disclosure, a semiconductor device is disclosed which comprising a semiconductor structure layer and a metal electrode on at least one surface of the semiconductor layer, wherein the metal electrode comprises at least one thin metal electrode section and at least one thick metal electrode section, preferably the at least one thin metal electrode section has a thickness of 4-7 $\mu$m and the at least one thick metal electrode section has a thickness of 9-14 $\mu$m.
Preferably the semiconductor structure layer comprising a p-well between the metal electrode and n hole barrier, wherein a plurality of trench gates being in contact with the metal electrode are placed such that they are reaching the n hole barrier, wherein between the trenches gates there are p++ areas, being in contact with the metal electrode, within the p-well, and wherein there is at least one p++ area which is in contact with a n++ emitter, which is in contact with the metal electrode.
Preferably all of the thin metal electrode sections are over all of the n++ emitters.
Preferably all of the thick metal electrode sections are over all of the n++ emitters.

Preferably W(Diode, front)+T(semiconductor)*2>W(Diode, electrode)>W(Diode, front)+T(semiconductor)/4 and/or W(Diode, back)+T(semiconductor)*2>W(Diode, electrode)>W(Diode, back)+T(semiconductor)/4

where W(Diode, front) is either a width of a thick metal electrode or is a width of a thin metal electrode,

T(semiconductor) is a thickness of the semiconductor structure,
W(Diode, front) is a width of the diode measured in the side of the metal electrode,
and
W(Diode, back) is a width of the diode measured in the side of the cathode.

According to a second example a method of ion implementation in a semiconductor device, preferably a reverse conducting insulated gate bipolar transistor, is disclosed. The method comprising steps of a. applying a resist on a surface of a semiconductor such that the resist forms a pattern, b. depositing a metal, preferably a Copper, preferably by means of electroplating, on areas not covered by the resist, c. removing of the resist, d. implementing ions.

Preferably before step a an at least one additional step of metal deposition is performed, and preferably after step c a metal etching step is performed.

Preferably two metals are deposited, namely a first metal layer and a second metal layer.

Preferably the first metal layer is made of Titanium, and where the second metal layer is made of Copper or Nickel.

Preferably the first metal layer has a thickness of 0,05-0,2 $\mu$m and/or the second metal layer have a thickness of 0,05-0,2 $\mu$m.

Preferably ions are H+ or He+, preferably with the energy of 2-23 MeV.

Preferably an additional step of back surface grinding is performed, preferably in the case where all of thin metal electrode sections are over all of n++ emitters.

Preferably before step d step e is performed of etching the metal.

BRIEF DESCRIPTION OF THE DRAWINGS

The disclosure will now be discussed with reference to the drawings, which show in:

Fig. 1 - Cross-section of RC-IGBT manufactured with a conventional technology;
Fig. 2 - Cross-section of RC-IGBT manufactured with a conventional technology where ions have been implemented in designated areas;
Fig. 3 - Technique of combining the lifetime implantation region by light ion irradiation by conventional technique;
Fig. 4 - First example of the disclosure;
Fig. 5 - Second example of the disclosure.
Fig. 6 - The cross-section at the chip edge to active area in the process;
Fig. 7 - Metal deposition step;
Fig. 8 - Applying resist step;
Fig. 9 - Electroplating Cu, thickness of 16 $\mu$m;
Fig. 10 - Resist removal step;
Fig. 11 - Metal etching step;
Fig. 12 - H+ implantation step;
Fig. 13 - implementation area after step from fig. 15;
Fig. 14 - Back surface grind step;
Fig. 15 - Back side processing step;
Fig. 16 - thick metal electrode forming step;
Fig. 17 - Proton irradiation step;
Fig. 18 - implementation area after step from fig. 20;
Fig. 19 - Wafer thinning step;
Fig. 20 - device from fig. 18 with dimensions shown
Fig. 21 - graph showing physical properties in relation to particular dimensions;
Fig. 22 - device from fig. 21 with dimensions shown

DETAILED DESCRIPTION OF THE DISCLOSURE

For a proper understanding of the disclosure, the detailed description below uses identical reference numerals in the drawings to denote corresponding elements or parts.

An RC(Reverse Conduction)-IGBT is a semiconductor chip that combines both an Insulated Gate Bipolar Transistor, IGBT 15 and a diode 14. To improve the diode's reverse recovery characteristics, light particles such as protons (H) or helium (He) are implanted into the diode 14 part to shorten the carrier lifetime to an appropriate value. However, shortening the carrier lifetime in the IGBT 15 section can deteriorate its electrical characteristics.

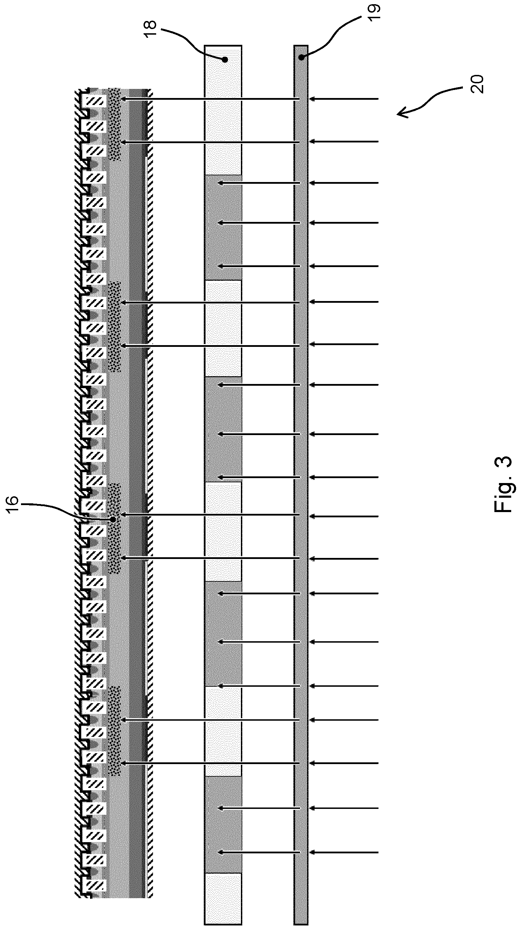

To address this, a metal mask is employed to confine the light particle implantation specifically to the diode 14 area, thereby preventing any impact on the IGBT's 15 carrier lifetime (see Fig. 3). Unlike the high precision alignment seen in modern photolithography semiconductor processes, aligning the metal mask to the chip on the wafer can have significant errors.

This disclosure aims to overcome the alignment issue, minimizing the error between the light particle implantation area and the diode pattern on the RC-IGBT chip.

An RC IGBT is a semiconductor chip that combines both an Insulated Gate Bipolar Transistor, IGBT, 15 and a diode 14. To improve the diode's reverse recovery characteristics, light particles such as protons (H) or helium (He) are implanted into the diode part to shorten the carrier lifetime to an appropriate value. However, shortening the carrier lifetime in the IGBT 15 section can deteriorate its electrical characteristics.

To address this, a metal mask 18 is employed to confine the light particle implantation specifically to the diode 14 area, thereby preventing any impact on the IGBT's 15 carrier lifetime (see Fig. 3). Unlike the high precision alignment seen in modern photolithography semiconductor processes, aligning the metal mask to the chip on the wafer can have significant errors.

This disclosure aims to overcome the alignment issue, minimizing the error between the light particle implantation area and the diode pattern on the RC-IGBT chip. It should be however understood that this disclosure may also be used in other semiconductor devices. In this disclosure a detailed structure of RC-IGBT is disclosed in figures, however one should understand that an exact semiconductor structure is not relevant - the way of determining a depth of the ion implementation in particular regions is important in the present disclosure.

Disclosure consists of 5 main aspects:

1. Reverse Conducting Insulated Gate Bipolar Transistor (Hereafter referred to as RC-IGBT), in which light ion particles are implanted, and the metal electrode 21 covering diode 14 part (Anode electrode) is thicker than that covering IGBT 15 part (Emitter electrode).
2. RC-IGBT, in which light ion particles are implanted, and the metal electrode 21 covering IGBT 15 part (Emitter electrode) is thicker than that covering diode 14 part (Anode electrode).
3. RC-IGBT, thick metal electrode 21b being thicker than thin metal electrode 21a by more than the half width of projected range of implanted light particles.
4. In the RC-IGBT, metal electrode 21 has a relation with width of anode diffusion or cathode diffusion, where a thick metal electrode 21b is W (diode, electrode), anode diffusion width in which n-type semiconductor working as emitter of IGBT 15 does not contains is W(diode, front), and the width of n-type diffusion formed on the other side of aforementioned electrode and on which p-type diffusion is not covering is W(diode, back).

W(Diode, front) + T(semiconductor) * 2 > W(Diode, electrode) > W(Diode, front) + T(semiconductor) / 4 and/or W(Diode, back) + T(semiconductor) * 2 > W(Diode, electrode) > W(Diode, back) + T(semiconductor) / 4

5. In the RC-IGBT second example of the disclosure, metal electrode 21 has a relation with width of anode diffusion or cathode diffusion, where a thin metal electrode 21a is W(diode, electrode), anode diffusion width in which n-type semiconductor working as emitter of IGBT 15 does not contains is W(diode, front), and the width of n-type diffusion formed on the other side of aforementioned electrode and on which p-type diffusion is not covering is W(diode, back).

W(Diode, front) + T(semiconductor) * 2 > W(Diode, electrode) > W(Diode, front) + T(semiconductor) / 4 and/or W(Diode, back) + T(semiconductor) * 2 > W(Diode, electrode) > W(Diode, back) + T(semiconductor) / 4

RC-IGBT is defined as power semiconductor chip. Both IGBT 15 part and diode 14 part are integrated into single chip and shared active area

By separating the IGBT 15 and diode 14 chips, the RC-IGBT can save the area of the termination 26. It is beneficial to manufacture packages, PCBs, and applications size compact. There is another benefit of the RC-IGBT according to the disclosure as the area of thermal conduction is larger than that in a conventional IGBT 15 and diode 14, because the IGBT 15 part and diode 14 part is spread over the chip unlike in the conventional IGBT 15 and diode 14.

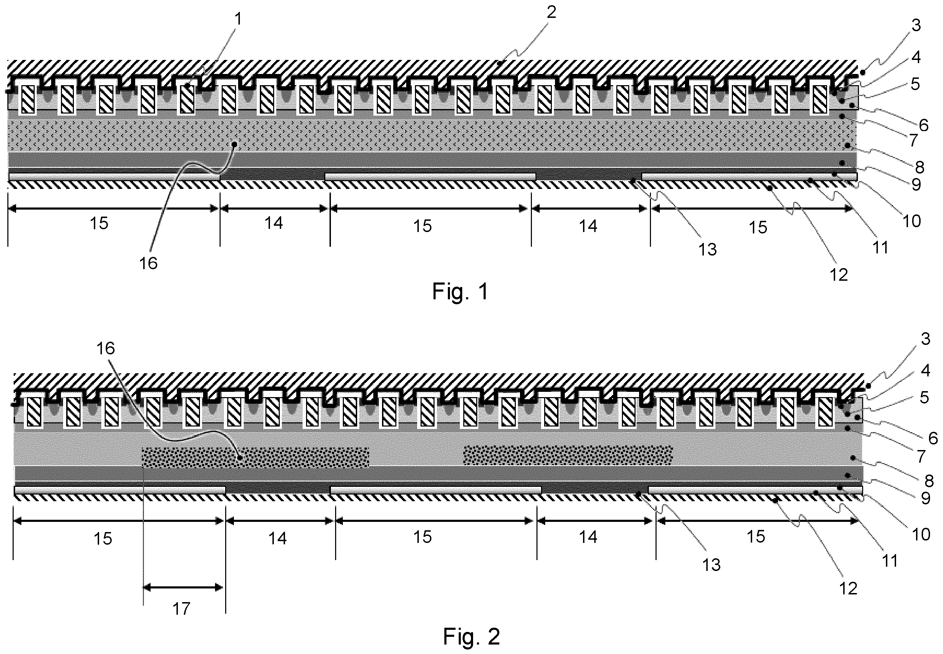

In Fig. 1 a schematic cross-section of RC-IGBT fabricated with a conventional technology is shown. On the front side of n(-) region 8 of the semiconductor wafer, a p(++) region 5, a p-well 6, and a n hole barrier 7 is formed through the process of photo-lithography, implantation, and diffusion. A trench gate 1 was formed by the process of photolithography, etching, and poly-Si deposition. An N(++) emitter 4 is formed on the IGBT 15 and no n(++) emitter 4 is formed on the diode 14 frontside. A barrier metal 3 and a metal electrode 2 is deposited on top.

On the back side n-type field stopper an n(+) field stopper was formed through process of implantation and annealing. At the bottom side of the IGBT 15 part, a p(+) collector 11 was formed through the process of photolithography, ion implantation and annealing. As a last manufacturing step, a backside metal was deposited.

In the example shown in Fig. 1 the wafer was irradiated with an electron beam and properly annealed to optimize its electric characteristics. An electron beam is not mandatory for the IGBT 15 to realize the most optimized IGBT 15 characteristics. On the other hand, lifetime control by beam irradiation is essential for the diode 14 not only from the characteristics point of view but also in view of robustness. The amount of electron beam is selected with the concession of the IGBT 15 characteristics and the diode 14 characteristics.

In this structure, the lifetime was controlled by the area limiting light ion implantation. The light ion in this structure is a proton ion (hereafter H+) accelerated to the energy of 4MeV by a cyclotron accelerator. The H+ particle was implanted by targeting the diode 14 area. In such case, inevitably H+ need to irradiate a much wider area than an optimized necessary area in order to avoid the existence of a nonirradiated area in the diode 14 part because of an alignment error between the metal mask 18 and the chip pattern on the wafer (see Fig. 2).

Through the irradiation and annealing process, short carrier lifetime regions where H+ was implanted and long carrier lifetime regions where H+ was not implanted were aligned in parallel.

Fig. 3 explains the technique of combining the lifetime implantation region by light ion irradiation 20 and the diode 14 pattern in the wafer by the conventional technique. The metal mask 18 with windows in the wafer and irradiation region 16 and a metal plate 19 without windows are stacked. In this technique, the metal mask 18 was installed on the back surface of the wafer, and H+ was irradiated from the back surface. H+ was blocked by the mask 18 in parts, yet propagated through the open window part. The metal mask 18 was made of stainless steel with a thickness of 500 $\mu$m. Here, the range of 4MeV protons is 100 $\mu$m, and the thickness of the 500 $\mu$m metal mask 18 is sufficient to prevent H+ from penetrating and reaching to the Si wafer material.

In addition, the metal plate 19 without windows and made of aluminium with a thickness of 120 $\mu$m was installed in the stack as an attenuator. H+ passed through the open window part and through the attenuator and its energy was attenuated. H+ that passed through the attenuator and passed through the window part of the metal mask 18 is implanted into the back surface of the Si wafer and penetrated to a depth of 43 $\mu$m. The half-width of the projection range of H+ in the wafer is 8 $\mu$m. The characteristics can be optimized by irradiating H+ within the distance where holes flowing from the diode 14 region and anode and electrons flowing from the cathode 13 diffuse laterally.

However, there is a mis-alignment 17 between the diode 14 region in the Si wafer and the metal mask 18. Therefore, H+ is irradiated within a distance that adds a mis-alignment 17 to the distance where the above carriers diffuse laterally. The characteristics can be improved by shortening the distance due to mis-alignment 17.

When the forward current of the diode 14 concentrates on the long lifetime region, the reverse recovery capability degraded. On the other hand, when the n(-) region 8 of the IGBT 15 becomes short lifetime, Vce(sat) becomes worse. Therefore, regional accuracy of light ion implantation contributes improvement of robustness and loss reduction. However, by the conventional technology high resolution alinement could not be achieved.

The mis-alignment 17 can be explained. Backside etching is performed for background and strain removal before H+ is implanted. As a result, the wafer thickness changes from 550 $\mu$m to 70 $\mu$m. The wafer periphery is not back-grinded and framed with the thickness and width of 550 $\mu$m and 5 mm, respectively. Only the inside of the wafer becomes thin. There is a notch on the outer periphery of the wafer, which indicates the main orientation of the wafer, and is also used for alignment with the metal mask 18. On the surface of the wafer, SiO$_2$ film and metal electrodes are deposited. SiO$_2$ and metal electrodes have different thermal expansion coefficients from Si, so there is high stress between Si and the film. When the wafer thickness changes from 550 $\mu$m to 70 $\mu$m, the wafer bends greatly.

The ungrounded edge on the outer periphery of the wafer can retain the shape of the wafer, however the bent of the inner part is large to generates difficulty of high-resolution alignment. On the back surface of the wafer, a metal mask 18 with windows in the light ion implantation region and an Al plate that serves as an attenuator are pre-set. H+ particles accelerated by a cyclotron are irradiated from below the Al-made attenuator. The alignment is not performed on a chip-by-chip basis but is aligned with the wafer by the outer periphery and notch of the wafer. The alignment accuracy between the chip and the window on the metal mask 18 is less than 1/10 of the alignment accuracy used in the wafer process due to the position accuracy of the notch and the large warpage of the wafer, and results in an mis-alignment 17 of about 20 $\mu$m or more

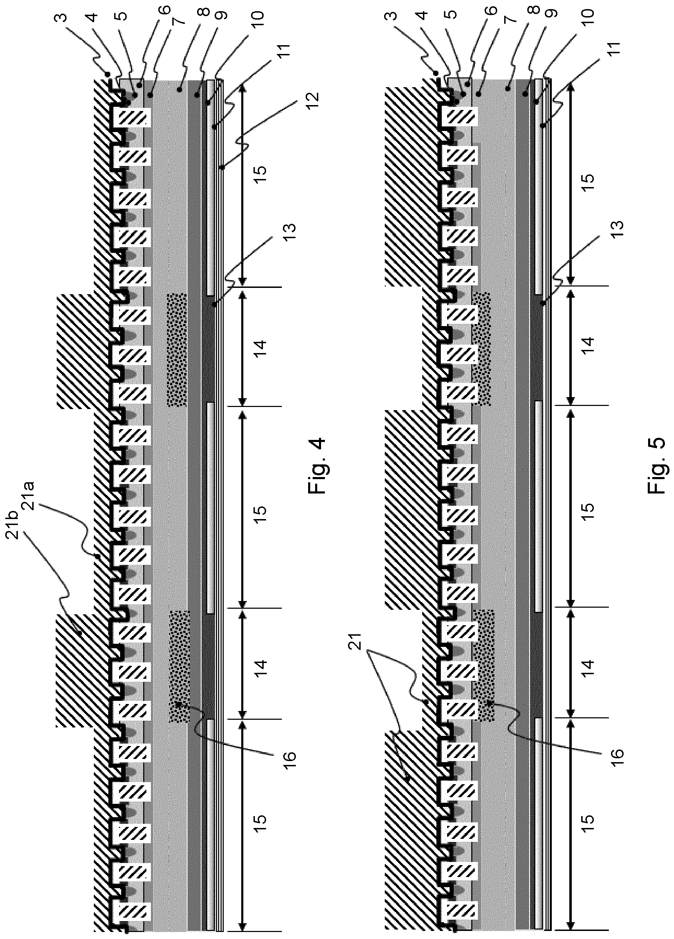

Fig. 4 shows a first example of the present disclosure. The IGBT 15 part of the RC-IGBT has an n(++) emitter 4 on the surface side of the Si, and a p(+) collector 11 on the back side. On the other hand, the diode 14 part has no n(++) emitter 4 on the surface side of the Si and the electrode contacts the p-well 6 and p(++) region 5. Also, there is no p(+) collector 11 on the back side, and the metal electrode contacts the n(+) surface. The metal electrode 21 of this diode 14 part, thick metal electrode 21b, is thicker than the metal electrode 21 of the IGBT 15 part, thin metal electrode 21a. A short carrier-lifetime (hereafter lifetime) layer is formed in the n(-) layer of the diode 14 part by H+ implantation - a irradiation region 16. The half-width of the short lifetime layer is 8 $\mu$m, and there is a peak of the short lifetime layer at a depth of 15 $\mu$m from the back electrode and 55 $\mu$m from the surface.

A barrier metal of Titanium alloy (Ti) with a thickness of 0.1 $\mu$m and an electrode of Copper alloy (Cu) with a thickness of 4 $\mu$m are deposited on the metal electrode on the IGBT 15.

As for the diode 14 part, a barrier metal of Ti with a thickness of 0.1 $\mu$m and an electrode of Cu with a thickness of 20 $\mu$m are deposited on the metal electrode.

The difference in thickness of the electrodes between the IGBT 15 part and the diode 14 part is 16 $\mu$m, which is larger than the half width of short lifetime layer: 8 $\mu$m.

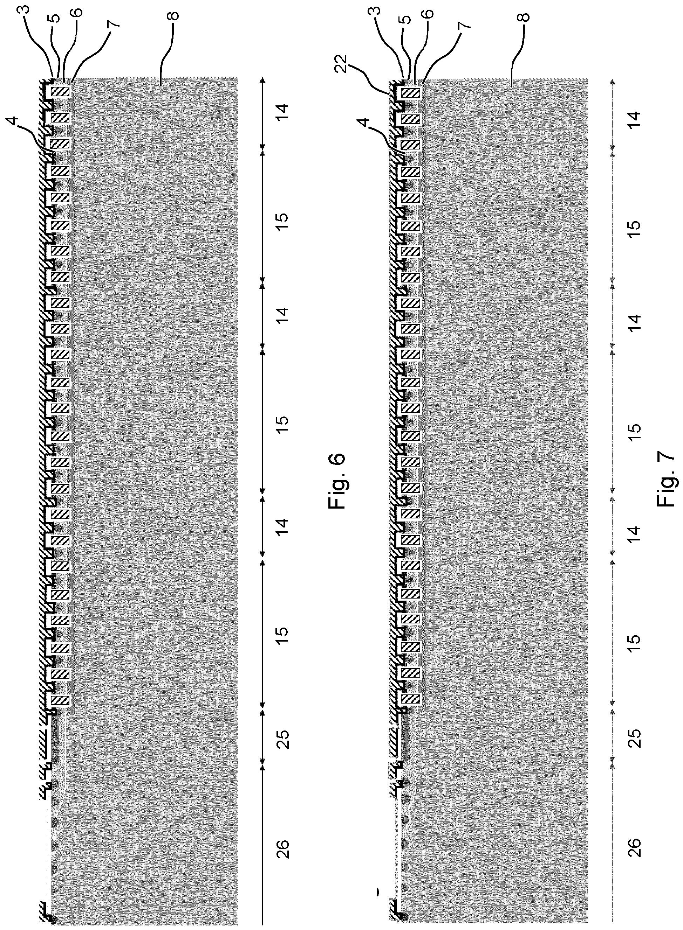

Using Fig. 6 to 15, the fabrication process flow according to the disclosure is explained.

Fig. 6 shows the cross-section at the chip edge to active area in the process. On the wafer, the same structure is replicated and more than 100 chips are fabricated by the same process. Front side photolithography, etching, ion-implantation, diffusion, and deposition are completed at this stage. The wafer thickness is 550 $\mu$m. Until this structure, the process flow is the same as in the prior art.

Next, a n(+) emitter is formed on the IGBT 15 part and no n(+) emitter is formed on the diode 14 part.

Subsequently, a metal electrode of Ti (0.1 $\mu$m in thickness) and Cu (4 $\mu$m in thickness) were deposited and patterned.

Fig. 7 shows the Ti and Cu deposition, with a thickness 0.05 $\mu$m and 0.05 $\mu$m, deposited on all surfaces.

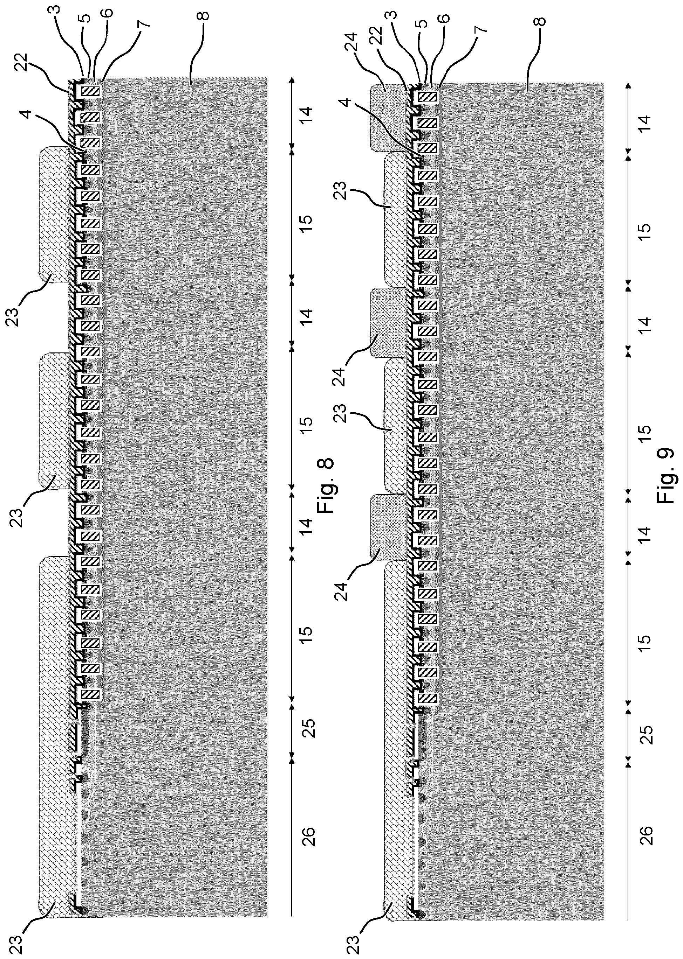

Fig. 8 shows the step of photolithography of the resist 23 on the IGBT 15 part.

Fig. 9 shows the step of electroplating Cu, with a thickness of 16 $\mu$m, thus forming an electroplated metal layer 24.

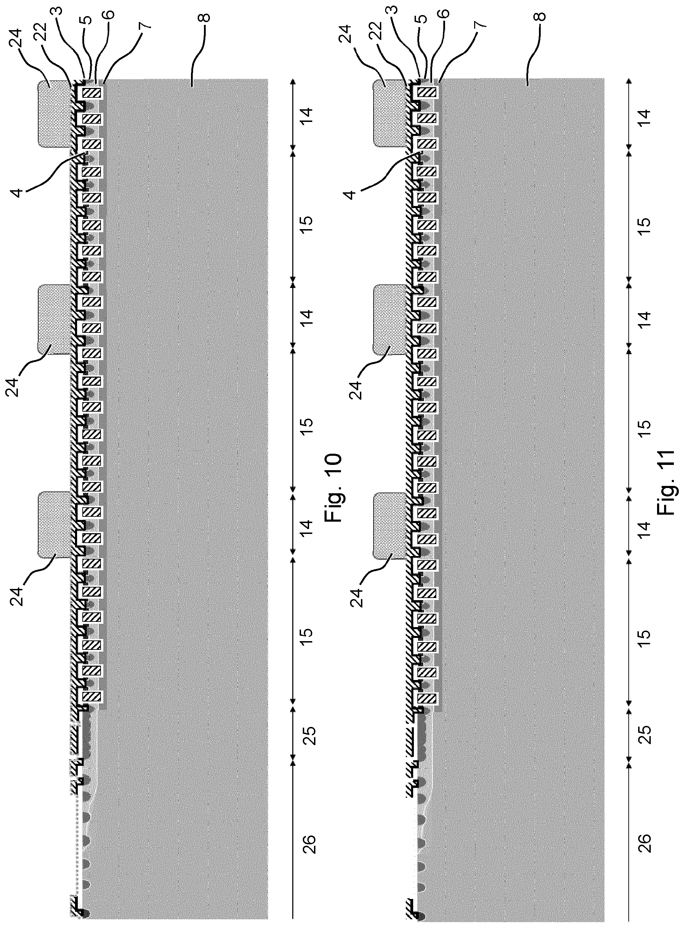

Fig. 10 shows the step of the resist 23 removal.

Fig. 11 shows the step of metal etching 0.12 $\mu$m on the whole wafer.

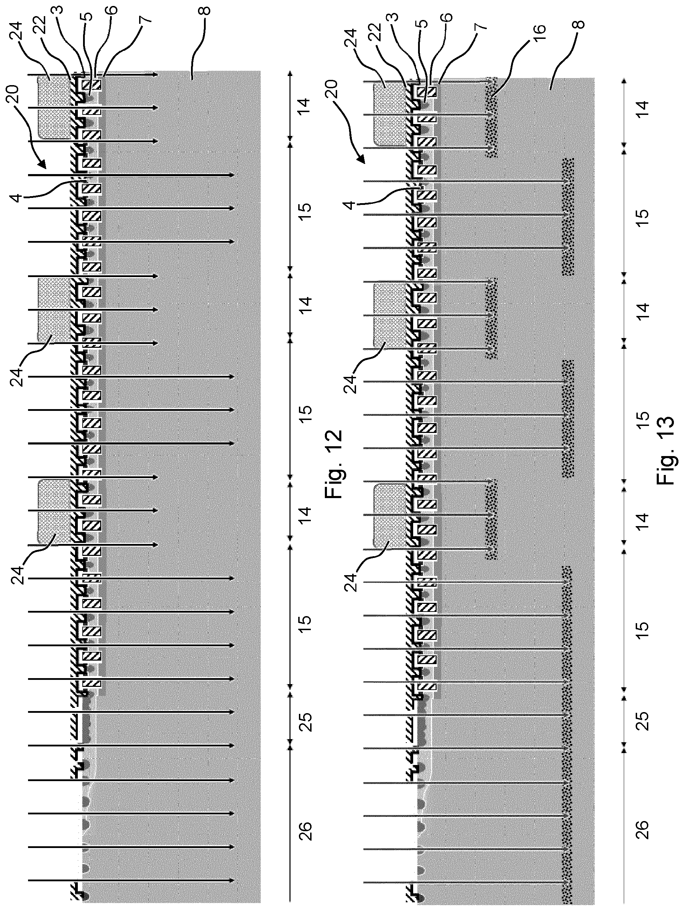

Fig. 12 shows the step of the H+ implantation, with the energy of 4 MeV.

The attenuator is not shown but actually installed. The thickness of the Al attenuator is selected to realize the targeted depth of H+ implantation.

Fig. 13 shows the depth of the induced short carrier lifetime layer of 55 $\mu$m under a thick metal electrode 21b and of 85 $\mu$m under a thin metal electrode 21a. In this example, the thick metal electrode 21b is formed over the diode 14 area and the thin metal electrode 21a is formed over the IGBT 15.

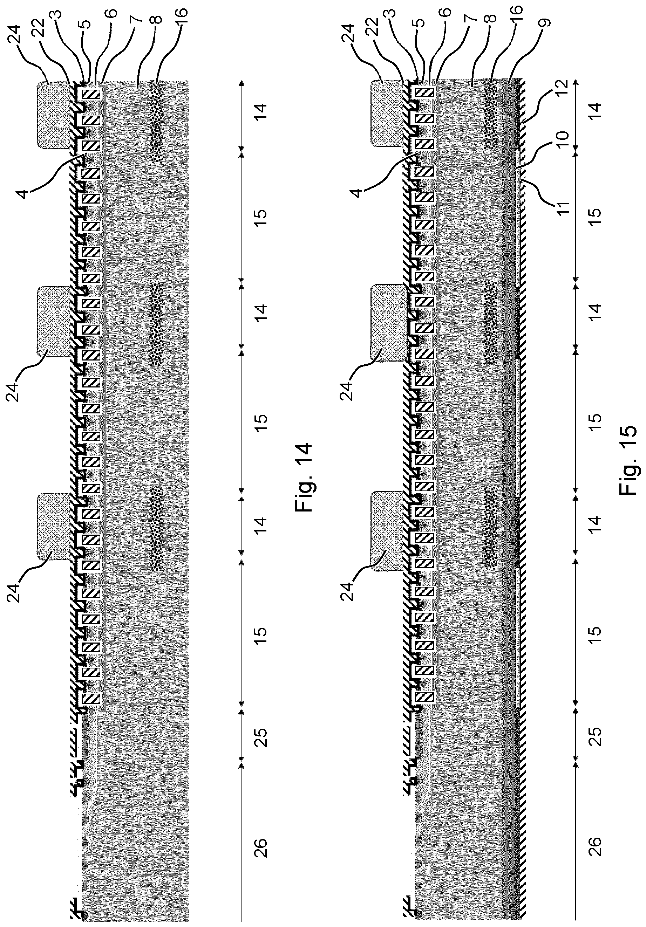

Fig. 14 shows the steps of the back surface grinding, polishing and wet etching to remove defect layers. The resulting thickness of Si is 75 $\mu$m. The short lifetime area in the IGBT 15 part is removed.

Fig. 15 shows the final step of back side process (implantation, photolithography, thermal annealing, metal deposition) after which the wafer process is completed.

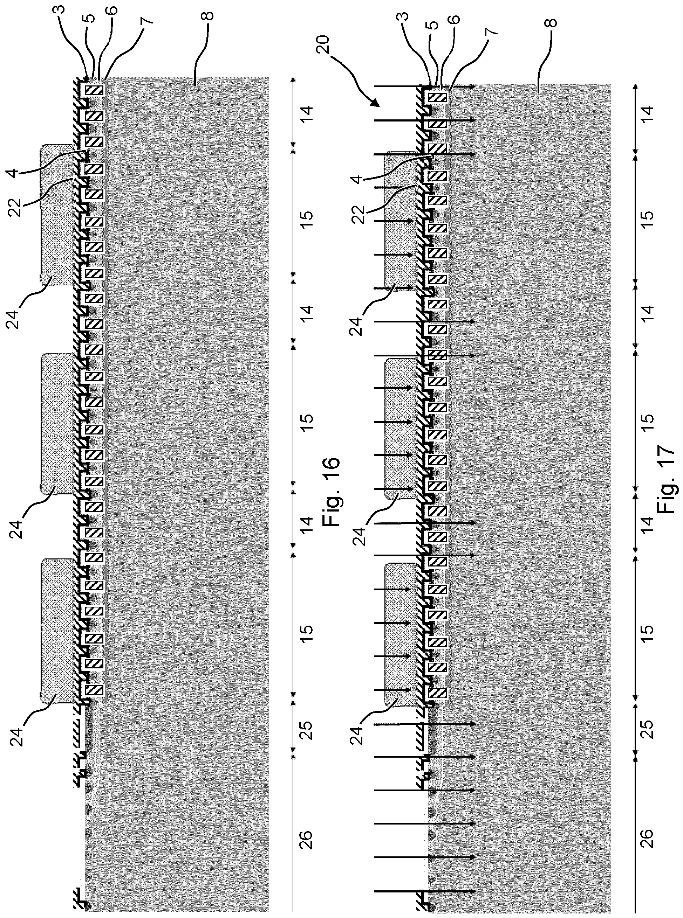

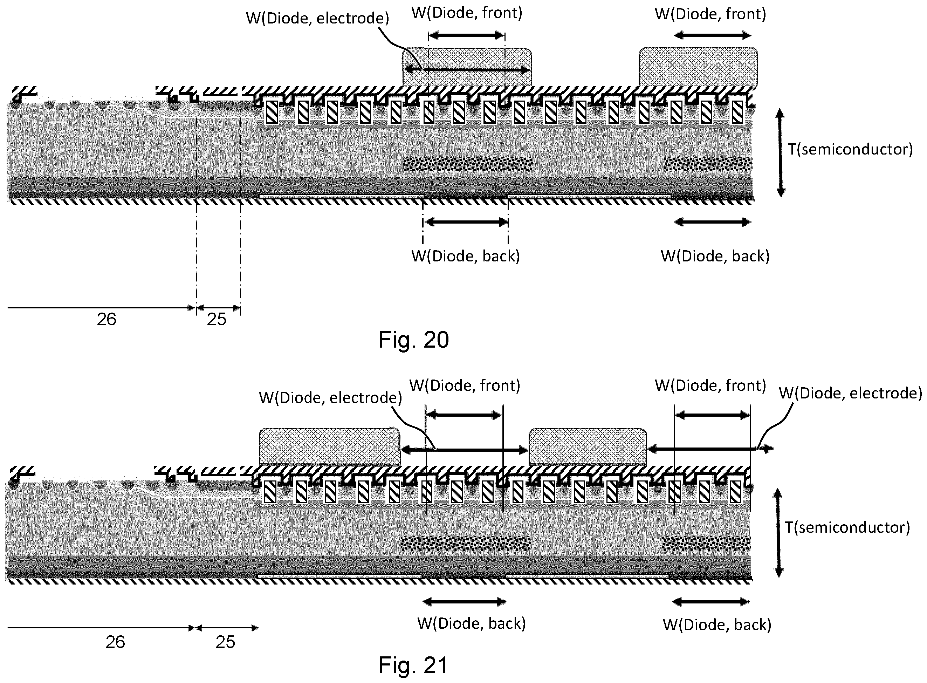

According to the second example of the disclosure, a metal electrode over the IGBT 15 part is thicker than that over the diode 14 part. In such example, the same process flow as depicted in Fig. 6 to Fig. 10 is followed, but the resist 23 pattern is over the diode 14 part. Eventually a thick metal electrode is formed over the IGBT 15 part as seen in Fig. 16. Subsequent steps as shown in Fig. 20-22 are performed wherein:

Fig. 17 shows the proton irradiation 20 step. The Al attenuator is thicker than in example 1. Protons reach the Si at the thin metal electrode 21a, whereas the H+ are blocked by the thick metal electrode 21b and stopped in the metal electrode.

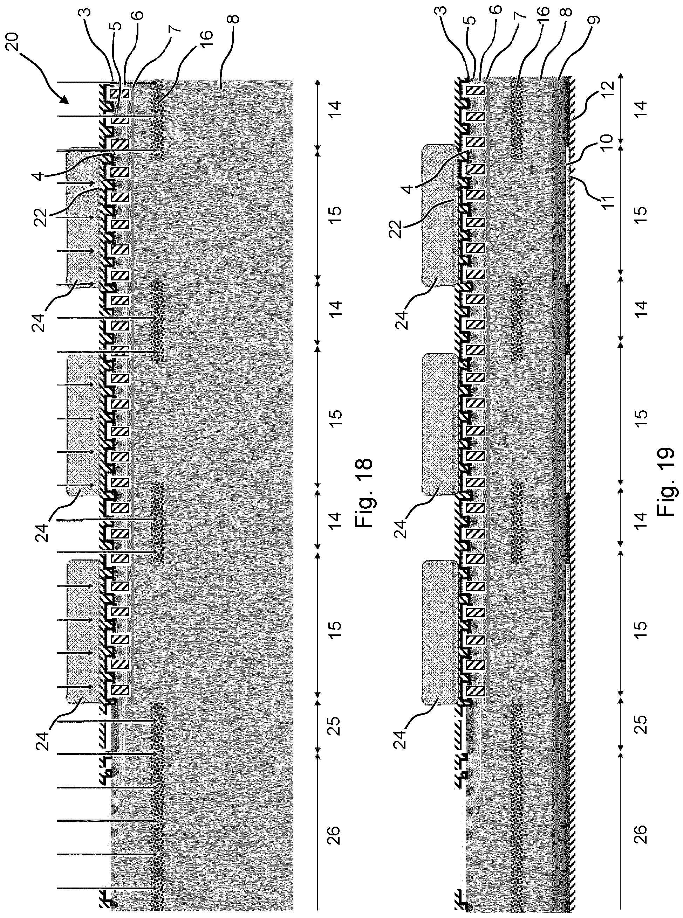

Fig. 18 shows the depth of the short lifetime layer under the thinner electrode, which is 20 $\mu$m.

Fig. 19 shows the steps of wafer thinning, back side processing.

A final product of the second example is shown in fig. 5.

According to another example of the disclosure the optimized width(stripe cell) or diameter(island cell) of thicker electrode is

$$W(Diode, front) + T(semiconductor) * 2 > W(Diode, electrode) > W(Diode, front) + T(semiconductor) \qquad (1)$$

and/or

$$W(Diode, back) + T(semiconductor) * 2 > W(Diode, electrode) > W(Diode, back) + T(semiconductor) \qquad (2).$$

The width of the thick electrode is the same as the width of the short lifetime area. That means that all ions are blocked by the thick electrode and in those areas there is no ion implementation in the semiconductor.

If the width is narrower than taken from formula (1) or (2), the diode 14 on-state current density at the border of the IGBT 15 part and the diode 14 part is higher than at the middle of the diode 14. Therefore, the reverse recovery durability and the surge current capability of diode 14 becomes weaker.

If the short lifetime area is wider than that from the formula (1) or (2) the IGBT 15 corrector current flow is hindered by the short lifetime area and the Vce(sat) becomes high.

In the case of a next example, the optimized width(stripe cell) or diameter(island cell) of the thinner electrode is

$$W(Diode, front) + T(semiconductor) * 2 > W(Diode, electrode) > W(Diode, front) + T(semiconductor) \qquad (3)$$

and/or

$$W(Diode, back) + T(semiconductor) * 2 > W(Diode, electrode) > W(Diode, back) + T(semiconductor) \qquad (4)$$

where W(Diode, front) is a distance between the thick electrodes 21b, T(semiconductor) is a thickness of the semiconductor structure, W(Diode, front) is a width of the diode 14 measured in the side of the metal electrode 21, and W(Diode, back) is a width of the diode 14 measured in the side of the cathode 13.

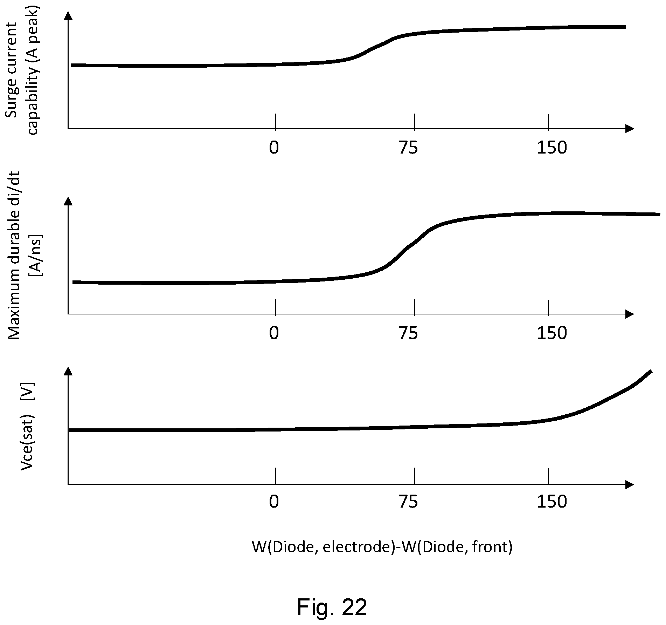

The formula is the same as formula (1) and (2). The same effect as previously outlined may be obtained. The dimensions for the formulas (1)-(4) are shown in figs. 20 and 21. In fig. 22 the physical parameters in relation to a difference between W(Diode, electrode) and W(Diode, back) are shown.

To define a thickness of both the thin metal electrode 21a and the thick metal electrode 21b it is important to determine what a difference of an ion penetration has to be in regions below the thin metal electrode 21a and the thick metal electrode 21b. This difference may be calculated as a difference in the height of the thin metal electrode 21a and the height of the thick metal electrode 21b multiplied by a ratio of a mass density of an electrode material to a mass density of the semiconductor material. Typically the thin metal electrode 21a has a thickness of 6 $\mu$m and the thick metal electrode 21b will have a thickness of 11,26 $\mu$m for Copper and Nickel and a thickness of 10,26 $\mu$m for lead solder.

LIST OF REFERENCE NUMERALS USED

| | |
|---|---|
| 1 | trench gate |
| 2 | metal electrode |
| 3 | barrier metal electrode |
| 4 | n(++) emitter |
| 5 | p(++) region |
| 6 | p-well |
| 7 | n hole barrier |
| 8 | n(-) region |
| 9 | n field stopper |
| 10 | n(+) field stopper |
| 11 | p(+) collector |
| 12 | metal electrode |
| 13 | cathode |
| 14 | diode |
| 15 | IGBT |
| 16 | irradiation region |
| 17 | mis-alignment |
| 18 | metal mask |
| 19 | metal plate |
| 20 | irradiation |
| 21 | metal electrode |
| 21a | thin metal electrode |
| 21b | thick metal electrode |
| 22 | deposited metal layer |
| 23 | resist |
| 24 | electroplated metal layer |
| 25 | gate line |
| 26 | termination |

**Claims**

1. A semiconductor device comprising a semiconductor structure layer and a metal electrode on at least one surface of the semiconductor layer, wherein the metal electrode comprises at least one thin metal electrode section and at least one thick metal electrode section, preferably the at least one thin metal electrode section has a thickness of 4-7 $\mu$m and the at least one thick metal electrode section has a thickness of 9-14 $\mu$m.

2. The semiconductor device according to claim 1, wherein the semiconductor structure layer comprising a p-well between the metal electrode and n hole barrier, wherein a plurality of trench gates being in a contact with the metal electrode are placed such that they are reaching the n hole barrier, wherein between the trenches gates there are p++ areas, being in contact with the metal electrode, within the p-well, and wherein there is at least one p++ area which is in contact with a n++ emitter, which is in contact with the metal electrode.

3. The semiconductor device according to claim 2, wherein all of the thin metal electrode sections are over all of the n++ emitters.

4. The semiconductor device according to claim 2, wherein all of the thick metal electrode sections are over all of the n++ emitters.

5. The semiconductor device according to anyone of the preceding claims 2-4, wherein W(Diode, front) + T(semiconductor) * 2 > W(Diode, electrode) > W(Diode, front) + T(semiconductor) / 4 and/or W(Diode, back) + T(semiconductor) * 2 > W(Diode, electrode) > W(Diode, back) + T(semiconductor) / 4,

where W(Diode, front) is either a width of a thick metal electrode or a width of a thin metal electrode,
T(semiconductor) is a thickness of the semiconductor structure,
W(Diode, front) is a width of the diode measured in the side of the metal electrode, and
W(Diode, back) is a width of the diode measured in the side of the cathode.

6. A method of ion implementation in a semiconductor device, preferably a reverse conducting insulated gate bipolar transistor, comprising steps of:

a) applying a resist on a surface of a semiconductor such that the resist forms a pattern,
b) depositing a metal, preferably a Copper, preferably by means of electroplating, on areas not covered by the resist,
c) removing of the resist,
d) implementing ions.

7. The method according to claim 6, wherein before step a) an at least one additional step of metal deposition is performed, and preferably after step c) a metal etching step is performed.

8. The method according to claim 7, wherein two metals are deposited, as a first metal layer and a second metal layer.

9. The method according to claim 8, wherein the first metal layer is made of Titanium, and where the second metal layer is made of Copper or Nickel.

10. The method according to claim 8 or 9, wherein the first metal layer has a thickness of 0,05-0,2 $\mu$m and/or the second metal layer has a thickness of 0,05-0,2 $\mu$m.

11. The method according to claim 6 or 7, wherein ions are H+ or He+, preferably with the energy of 2-23 MeV.

12. The method according to anyone of claims 6-8, wherein an additional step of back surface grinding is performed, preferably in the case where all of thin metal electrode sections are over all of n++ emitters.

13. The method according to anyone of previous claims, wherein before step d) a step e) of etching the metal is performed.

Fig. 1

Fig. 2

18

19

20

16

Fig. 3

Fig. 4

Fig. 5

Fig. 6

Fig. 7

EP 4 672 340 A1

**Fig. 8**

23     23     23     4    22    3    5    6    7    8

26    25    15    14    15    14    15    14

**Fig. 9**

23    24    23    24    23    4    24    22    3    5    6    7    8

26    25    15    14    15    14    15    14

13

Fig. 10

Fig. 11

EP 4 672 340 A1

Fig. 12

Fig. 13

Fig. 14

Fig. 15

Fig. 16

Fig. 17

EP 4 672 340 A1

Fig. 18

Fig. 19

Fig. 20

Fig. 21

Fig. 22

Surge current
capability (A peak)

Maximum durable di/dt
[A/ns]

Vce(sat) [V]

W(Diode, electrode)-W(Diode, front)

Europäisches
Patentamt

European
Patent Office

Office européen
des brevets

# EUROPEAN SEARCH REPORT

**Application Number**

EP 24 18 4707

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/269063 A1 (KODAMA NAOKO [JP]) 20 September 2018 (2018-09-20) * paragraph [0057] - paragraph [0071]; figure 1 * | 1-13 | INV. H01L29/32 H01L29/739 |
| X | US 2021/166944 A1 (TABUCHI SHINICHI [JP] ET AL) 3 June 2021 (2021-06-03) * paragraphs [0026] - [0028], [0035] - [0041]; figures 1-7 * | 1-13 | |
| X | XIAOKUN WANG ET AL: "High-Voltage n-Channel IGBTs on Free-Standing 4H-SiC Epilayers", IEEE TRANSACTIONS ON ELECTRON DEVICES, IEEE, USA, vol. 57, no. 2, 1 February 2010 (2010-02-01), pages 511-515, XP011287239, ISSN: 0018-9383, DOI: 10.1109/TED.2009.2037379 * Section II; figure 1 * | 6-10,13 | |
| X | -& MATIN M ET AL: "A SELF-ALIGNED PROCESS FOR HIGH-VOLTAGE, SHORT-CHANNEL VERTICAL DMOSFETS IN 4H-SIC", IEEE TRANSACTIONS ON ELECTRON DEVICES, IEEE, USA, vol. 51, no. 10, 1 October 2004 (2004-10-01), pages 1721-1725, XP001211148, ISSN: 0018-9383, DOI: 10.1109/TED.2004.835622 * Section III * | 6-10,13 | TECHNICAL FIELDS SEARCHED (IPC) H01L |

The present search report has been drawn up for all claims

| Place of search | Date of completion of the search | Examiner |
|---|---|---|
| Munich | 14 November 2024 | Nikolka, Mark |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 24 18 4707**

This annex lists the patent family members relating to the patent documents cited in the above-mentioned European search report.
The members are as contained in the European Patent Office EDP file on
The European Patent Office is in no way liable for these particulars which are merely given for the purpose of information.

**14-11-2024**

| Patent document cited in search report | Publication date | Patent family member(s) | | Publication date |
|---|---|---|---|---|
| US 2018269063 A1 | 20-09-2018 | CN | 108630532 A | 09-10-2018 |
| | | JP | 7325167 B2 | 14-08-2023 |
| | | JP | 2018157017 A | 04-10-2018 |
| | | US | 2018269063 A1 | 20-09-2018 |
| US 2021166944 A1 | 03-06-2021 | CN | 111954926 A | 17-11-2020 |
| | | DE | 112018007456 T5 | 17-12-2020 |
| | | JP | 7036198 B2 | 15-03-2022 |
| | | JP | WO2019198182 A1 | 03-12-2020 |
| | | US | 2021166944 A1 | 03-06-2021 |
| | | WO | 2019198182 A1 | 17-10-2019 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022167435 A

- JP 2021190496 A